# EUROPÄISCHE PATENTANMELDUNG

(11) **EP 0 827 183 A1**
(43) Veröffentlichungstag der Anmeldung: **04.03.1998**
(21) Anmeldenummer: 97710016.3
(22) Anmeldetag: 16.08.1997
(51) Int. Cl.: H01J 37/32

(54) **HF-durchlässiges Vakuumgefäss mit integriertem Faraday-Schirm**

(30) Priorität: 30.08.1996 DE 19635136
(71) Anmelder: Galvano-T electroforming-plating GmbH, 51570 Windeck-Rosbach (DE)
(72) Erfinder: Busch, Michael, 51570 Windeck-Rosbach (DE); Szcepaniak, Werner, 53783 Eitorf (DE); Heinemann, Bernd, 85304 Ilmmünster (DE); Riedel, Rudolf, 81247 München (DE); Kraus, Werner, Dr., 85748 Garching (DE)

(57) **Zusammenfassung**

Es wird ein HF-durchlässiges Vakuumgefäß mit integriertem Faraday-Schirm bestehend aus einem Bodenteil (1) und einem Mantelteil (2) beschrieben, bei welchem das Mantelteil (2) aus zwei konzentrischen metallischen Schichten (2a, 2b) besteht, jede Schicht (2a, 2b) mit einer Vielzahl von in Längsrichtung verlaufenden Schlitzen (8,9) versehen ist, und die Schichten (2a, 2b) durch Abstandshalter ( 2c) aus vakuumdichten, dielektrischen Werkstoff in Abstand zueinander gehalten sind.

## Beschreibung

Die Erfindung betrifft ein HF-durchlässiges Vakuumgefäß mit integriertem Faraday-Schirm.

Derartige Gefäße werden insbesondere für Hochfrequenz-Plasmageneratoren in der Plasmatechnologie, für Hochfrequenz-Ionenquellen für die Erzeugung von Plasmen zur Extraktion von positiven oder negativen Ionen für die Neutralinjektion u.ä.Anwendungen benötigt.

Aus einem Artikel von W.Kraus, J.H.Feist, E.Speth und R.Wilhelm vom Max-Planck-Institut für Plasmaphysik " A High Power RF Plasma Source For ASDEX Upgrade Neutral Beam Injection " erschienen in Fusion Technology 1994 ist eine Hochfrequenz-Quelle mit dreischaligem Wandaufbau bekannt. Das Plasma wird eingeschlossen in einem Quarzgefäß, das stirnseitig vakuumdicht abgeschlossen ist. Die Hochfequenzspule ist außerhalb des Plasmas um das Quarzgefäß herumgewickelt. Auf der Innenseite wird die Quarzwand durch einen Faraday-Schirm von dem chemisch aggressiven Plasma geschützt und damit Erosion und eine ungewollte Deposition von Siliziumdioxid vermieden. Der Faraday-Schirm hat eine Vielzahl von Längsschlitzen, um für die Hochfrequenzenergie durchlässig zu sein. Außerdem ist außerhalb des Quarzgefäßes ein zusätzlicher Vakuumtank vorgesehen, da das Quarzgefäß bei einem nichtrunden Querschnitt dem Atmosphärendruck nicht standhalten würde.Eine aktiv gekühlte Rückplatte mit zahlreichen Permanentmagneten ist innerhalb des Quarzgefäßes angeordnet. Dieser zusätzliche Vakuumtank erschwert die Montage, die Zugänglichkeit und den gesamten Aufbau erheblich, zumal über geeignete Mittel evakuiert werden muß, und die Druckdifferenz zwischen Innen- und Außenraum des Isolationsgefäßes entsprechend überwacht werden muß.

Ein weiterer Nachteil besteht darin, daß die Hochfrequenzspule bei dieser bekannten Anordnung im Vakuum liegt, was zusätzliche Probleme bei der elektrischen Isolierung der Spule und der Durchführung der Anschlußleitung für die Hochfrequenzspule aufwirft.

Der Erfindung liegt die Aufgabe zugrunde, das bekannte Vakuumgefäß dahingehend zu verbessern, daß ein wesentlich kompakterer Aufbau mit geringeren Außenabmessungen erzielt wird und auf ein zusätzliches Vakuumgefäß verzichtet werden kann.

Diese Aufgabe wird durch die im Anspruch 1 erfaßten Merkmale gelöst.

Neben den sich aus der Aufgabenstellung direkt ergebenden Vorteilen weist die Erfindung noch weitere Vorteile auf.

Zwischen Hochfrequenzspule und Plasma ist nunmehr ein Abstand von weniger als 10 mm möglich. Da die Hochfrequenzspule sich bei Verwendung des Vakuumgefäßes nach der Lehre der Erfindung nicht mehr im Vakuum sondern in Luft befindet, sind kürzere Isolierstrecken möglich, das Isolationsmaterial muß nicht vakuumtauglich sein und auf aufwendige Vakuumdurchführungen für die Zuleitungen der Hochfrequenzspule kann verzichtet werden. Sowohl die Hochfrequenzspule als auch die Permanentmagnete sind bei dieser Anordnung leicht zugänglich.

Weitere vorteilhafte Ausgestaltungen der Erfindung sind in den Unteransprüchen erfaßt.

Die Erfindung ist anhand der in den Figuren 1 bis 4 schematisch dargestellten Ausführungsbeispiele näher erläutert.

Es zeigen:
- Figur 1 :: einen Schnitt durch einen Teil einer Hochfreqenz-Ionenquelle mit einem Vakuumgefäß gemäß der Lehre der Erfindung
- Figur 2 :: einen Schnitt durch einen Teil der Wandung des Vakuumgefäßes quer zur Längsachse
- Figur 3 :: einen Schnitt durch die Wandung des Vakuumgefäßes in Längsrichtung
- Figur 4 :: eine Ansicht auf die Außenoberfläche des Vakuumgefäßes, teilweise gebrochen.

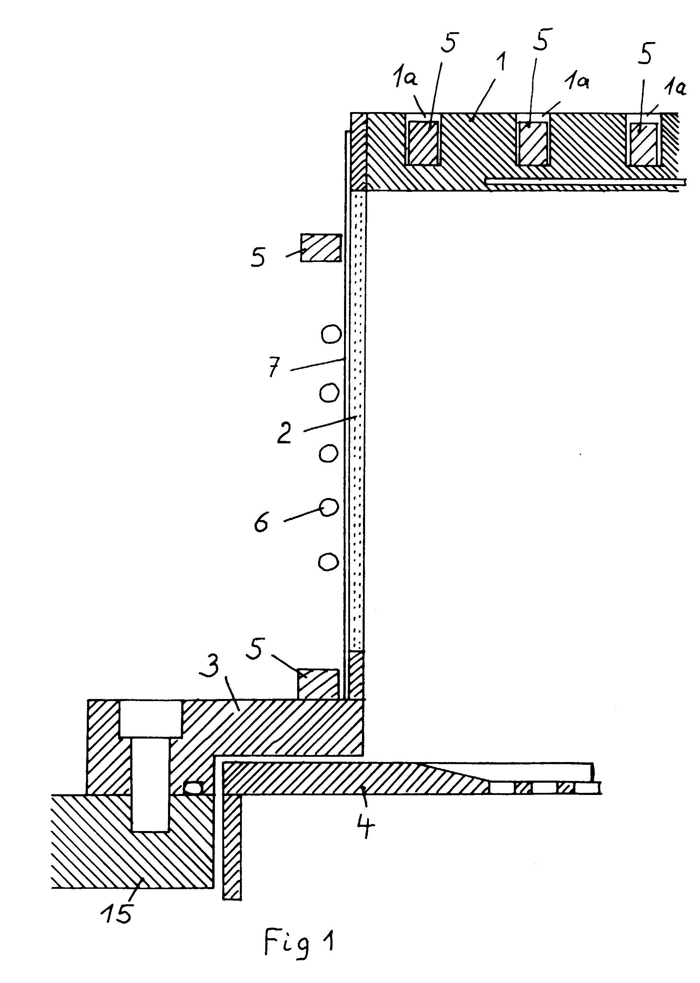

In der Figur 1 ist mit 1 die Rückplatte bzw. das Bodenteil, mit 2 das Mantelteil und mit 3 der Flansch bezeichnet. Diese Teile bilden das Vakuumgefäß. Die Ionenquelle besteht ferner aus dem Plasmagitter 4 und und wird montiert auf dem HV-Flansch 15. In dem Bodenteil 1 sind Ausnehmungen la für Permanentmagnete 5 vorgesehen. Weitere Permanentmagnete 5 sind außerhalb des Mantelteils 2 angeordnet. Eine isolierte Hochfrequenzspule 6 umgibt das Mantelteil 2. Zwischen Mantelteil 2 und Hochfrequenzspule 6 ist noch eine Isolierschicht 7 vorgesehen. Das Mantelteil 2 ist sowohl mit dem Bodenteil 1 als auch mit dem Flansch 3 metallisch und vakuumdicht verbunden.

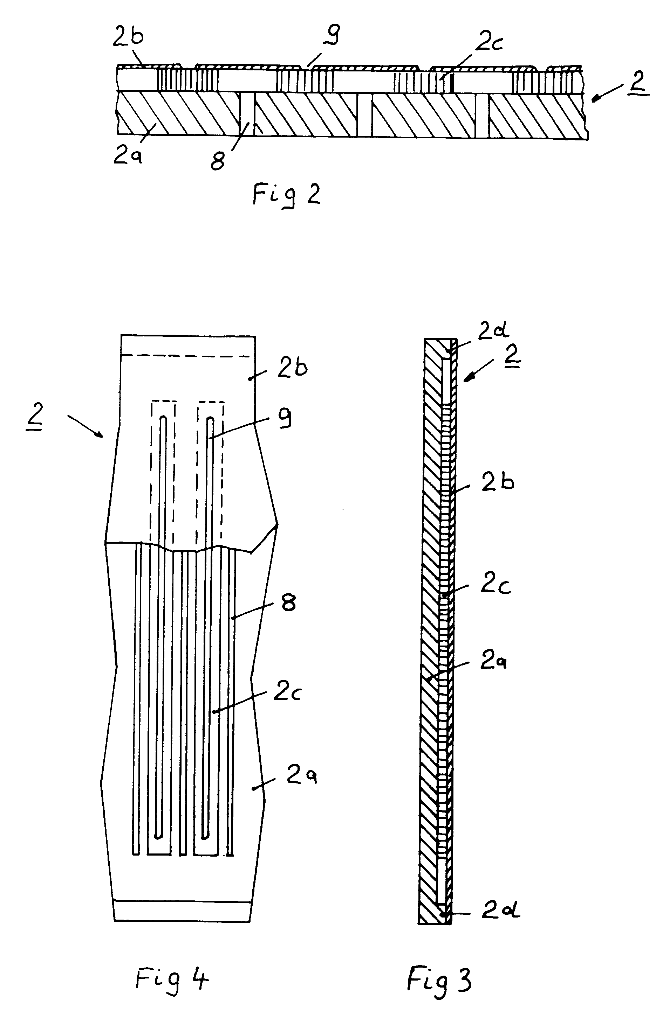

Die Figur 2 zeigt, daß das Mantelteil 2 aus einer inneren Schicht 2a und einer äußeren Schicht 2b besteht. Zwischen den Schichten 2a und 2b sind Abstandshalter 2c vorgesehen. Die Schichten 2a und 2b sind auf galvanischem Wege aus Kupfer hergestellt. Galvanisch hergestelltes Kupfer hat eine Zugfestigkeit von ca.320 N / mm², seine Festigkeit liegt also in der Nähe der Festigkeit von Edelstahl . Wegen ähnlich großer Temperaturausdehnungskoeffizienten ist es darüberhinaus möglich, das aus Edelstahl bestehende Bodenteil 1 und den ebenfalls aus Edelstahl bestehenden Flansch 3 während des galvanischen Prozesses mit dem Mantelteil 2 vakuumdicht zu verbinden. Als Material für die Abstandshalter 2c werden bevorzugt Streifen aus einer Aluminiumoxidkeramik verwendet. Dieses Material ist vakuumdicht und läßt sich mit einer leitfähigen Beschichtung versehen.

In der inneren Schicht 2a sind eine Vielzahl von Längsschlitzen 8 gleichmäßig über die Fläche des Mantelteils 2 verteilt angeordnet. Desgleichen sind in der äußeren Schicht 2b Längsschlitze 9 vorgesehen. Die Keramikstreifen 2c liegen auf der inneren Schicht 2a, dem Innenmantel lediglich auf und stützen sich dort ab. Sie sind allerdings auf der nach außen weisenden Oberfläche mit der äußeren Schicht 2b, dem Außenmantel vakuumdicht verbunden. Sie bilden damit gemeinsam mit dem Außenmantel 2b eine vakuumdichte Hülle, die sich kraftmäßig auf dem Innenmantel 2a abstützt. An beiden Seiten ist der Außenmantel 2b an einem Kragen 2d des Innenmantels 2a vakuumdicht angeschlossen ( s.Figur 3). Die unterschiedlichen Temperaturausdehnungen zwischen den Keramikstreifen 2c und dem Material von Innenmantel 2a und Außenmantel 2b, welches vorzugsweise Kupfer ist, werden durch den freien elastischen Endbereich des Außenmantels 2b zwischen Keramikstreifen 2c und den Kragen 2d aufgenommen.

Wie in der Figur zu erkennen ist, sind die Längsschlitze 8 und 9 versetzt zueinander angeordnet, d.h. aus dem Innern des Vakuumgefäßes ist keine freie Sichtlinie zum Abstandshalter 2c möglich. Dadurch wird verhindert, daß das chemisch aggressive Plasma in Kontakt mit den Abstandshaltern 2c gelangt. Für den Durchtritt des Hochfrequenzfeldes ist diese versetzte Anordnung nicht hinderlich.

Die Figur 3 zeigt, daß die Längsschlitze 8 sich nicht über die gesamte Länge des Mantelteils 2 erstrecken.

Aus Figur 4 ist zu ersehen, daß die Längsschlitze 8 die gleiche Länge wie die Abstandshalter 2c aufweisen, die Längsschlitze 9 dagegen etwas kürzer sind.

Für ein Vakuumgefäß mit einem Innendurchmesser von 310 mm und einer Höhe des Innenraumes von ca. 165 mm haben sich folgende Abmessungen als besonders geeignet erwiesen:

| | |
|---|---|
| Wanddicke innere Schicht | 6 mm |
| Wanddicke Abstandshalter | 3 mm |
| Wanddicke äußere Schicht | 0,6 mm |
| Abstand der Längsschlitze | 16 mm |
| Breite der Längsschlitze | 2 mm |
| Länge der Längsschlitze innen | 155 mm |
| Länge der Längsschlitze außen | 150 mm |

Für Vakuumgefäße mit größerem Innenraum wird man einen nahezu ovalen Querschnitt vorziehen.

Bei einem bevorzugten Verfahren zur Herstellung eines Vakuumgefäßes nach der Lehre der Erfindung wird zunächst ein Kern hergestellt, dessen Querschnitt dem Querschnitt des Innenraumes des Vakuumgefäßes entspricht. Der Kern besteht aus elektrisch leitfähigem Material oder ist an seiner Oberfläche elektrisch leitfähig gemacht worden. Auf der Mantelfläche des Kerns werden an den Stellen, an denen sich die Schlitze 8 der inneren Schicht 2a befinden sollen, Stäbe aus dielektrischem Material, z.B.aus Polymethylmethacrylat befestigt. Die Stäbe haben die Länge und die Breite der Schlitze 8 und ihre Wanddicke ist gleich der Wanddicke der inneren Schicht 2a. An einem Ende des Kerns wird das aus Edelstahl bestehende Bodenteil 1 und am anderen Ende der ebenfalls aus Edelstahl bestehende Flansch 3 befestigt. Sowohl das Bodenteil 1 als auch der Flansch 3 werden vorzugsweise vorher verkupfert. In einem galvanischen Prozeß wird nun auf dem Kern eine Kupferschicht abgeschieden. Dabei werden das Bodenteil 1 und der Flansch 3 mit eingalvanisiert. Der Kern kann nun entfernt werden, und die Stäbe aus den Schlitzen 8 herausgenommen werden. Das nun vorliegende Gebilde ist ein topfartiger Behälter mit einem Flansch am Behälterrand und einer Vielzahl von in der Behälterwand befindlichen Längsschlitzen.

Auf den zwischen den Längsschlitzen 8 befindlichen Bereichen der Mantelfläche werden Stäbe aus Aluminiumoxidkeramik, die an einer Oberfläche an den Randbereichen mit einer Metallschicht versehen sind und vorher auf Vakuumdichtigkeit geprüft wurden, befestigt. Die zwischen den Stäben verbleibenden Bereiche werden mit Wachs ausgefüllt. Es besteht auch die Möglichkeit, zunächst die Oberfläche der Mantelfläche mit Wachsbändern zu umwickeln und die Keramikstäbe in in die Wachsschicht eingearbeitete Nuten einzulegen. Anschließend wird die Oberfläche der Wachsschicht elektrisch leitfähig gemacht. Auf die nach außen gerichtete metallisierte Oberfläche der Keramikstäbe ( Abstandshalter 2c ) wird eine der Form der Längsschlitze 9 in der äußeren Schicht 2b entsprechende Abdeckung aus dielektrischem Material aufgebracht. Nun wird in einem weiteren galvanischen Prozeß die äußere Schicht 2b erzeugt, wobei die Abstandshalter 2c ( Keramikstäbe ) in die Schicht 2b eingalvanisiert werden und die abgedeckten Bereiche auf den Abstandshaltern 2c freibleiben und die Schlitze 9 bilden. Abschließend wird das Wachs herausgeschmolzen.

Es versteht sich von selbst, daß die Schlitze 8 und 9 auch durch spanende Bearbeitung aus den galvanisch erzeugten Schichten 2a und 2b herausgearbeitet werden können, jedoch erfordert dies einen zusätzlichen Arbeitsgang.

## Patentansprüche

1. HF-durchlässiges Vakuumgefäß mit integriertem Faraday-Schirm bestehend aus einem Bodenteil (1) und einem Mantelteil (2), bei welchem das Mantelteil (2) aus zwei konzentrischen metallischen Schichten (2a, 2b) besteht, jede Schicht (2a, 2b) mit einer Vielzahl von in Längsrichtung verlaufenden Schlitzen (8,9) versehen ist, und die Schichten (2a, 2b) durch Abstandshalter ( 2c) aus vakuumdichten, dielektrischen Werkstoff in Abstand zueinander gehalten sind.

2. Vakuumgefäß nach Anspruch 1, dadurch gekennzeichnet, daß die Abstandshalter (2c) zwischen zwei benachbarten Schlitzen (8) der inneren Schicht (2a) angeordnet sind und dieSchlitze (9) der äußeren Schicht (2b) im Bereich der Abstandshalter (2c) angeordnet sind.

3. Vakuumgefäß nach Anspruch 1 oder 2, dadurch gekennzeichnet, daß der Querschnitt des Vakuumgefäßes kreisrund ist.

4. Vakuumgefäß nach Anspruch 1 oder 2, dadurch gekennzeichnet daß der Querschnitt des Vakuumgefäßes im wesentlichen oval ist.

5. Vakuumgefäß nach einem der Ansprüche 1 bis 4, dadurch gekennzeichnet daß die Schichten (2a, 2b) aus galvanisch abgeschiedenem Kupfer bestehen.

6. Vakuumgefäß nach einem der Ansprüche 1 bis 5, dadurch gekennzeichnet, daß die Abstandshalter (2c) aus keramischem Material bestehen.

7. Vakuumgefäß nach Anspruch 6, dadurch gekennzeichnet, daß das keramische Material Aluminiumoxid oder Glaskeramik ist.

8. Vakuumgefäß nach einem der Ansprüche 1 bis 7, dadurch gekennzeichnet, daß das Bodenteil (1) mit dem Mantelteil (2) metallisch verbunden ist.

9. Vakuumgefäß nach einem der Ansprüche 1 bis 8, dadurch gekennzeichnet, daß an dem dem Bodenteil (1) abgekehrten Ende des Mantelteils (2) ein Flansch (3) vorgesen ist, der metallisch mit dem Mantelteil (2) verbunden ist.

10. Vakuumgefäß nach einem der Ansprüche 1 bis 9, dadurch gekennzeichnet, daß in zumindest einer der Schichten (2a, 2b) des Mantelteils (2) Kühlkanäle vorgesehen sind.

11. Verfahren zur Herstellung eines Vakuumgefäßes nach einem der Ansprüche 1 bis 10, gekennzeichnet durch folgende Schritte :
a.) auf einem der Innenkontur des Vakuumgefäßes angepaßten Kern aus leitfähigem Werkstoff oder mit leitfähig gemachter Oberfläche werden Streifen aus dielektrischem Material an den für die Schlitze der inneren Schicht vorgesehenen Stellen befestigt.
b.) auf den Kern wird eine Kupferschicht galvanisch abgeschieden
c.) auf die Oberfläche der galvanisch abgeschiedenen Schicht wird eine Wachsschicht aufgebracht.
d.) in die Wachsschicht werden vakuumdichte Streifen aus keramischem Werkstoff eingebettet, die an ihrer nach außen weisenden Oberfläche elektrisch leitfähig gemacht sind, wobei die Streifen auf den zwischen den Schlitzen der innere Schicht befindlichen Stegen gelegen sind und eine Wanddicke aufweisen, welche der Wanddicke der Wachsschicht entspricht.
e.) die Oberfläche der Wachschicht wird elektrisch leitfähig gemacht
f.) die Streifen aus keramischem Material werden entsprechend der Form der Schlitze in der äußeren Schicht mit dielektrischem Material abgedeckt
g.) auf die Oberfläche der Wachsschicht und der nicht abgedeckten Bereichen der Streifen aus keramischem Material wird eine die äußere Mantelschicht bildende Kupferschicht galvanisch abgeschieden.

12. Verfahren nach Anspruch 11, dadurch gekennzeichnet, daß auf den Kern das Bodenteil und der Flansch elektrisch leitend befestigt werden.
